# EUROPEAN PATENT APPLICATION

(11) **EP 4 749 918 A1**
(43) Date of publication of application: **27.05.2026**
(21) Application number: 25215254.1
(22) Date of filing: 12.11.2025
(51) Int. Cl.: H03F 1/30, H03F 3/30, H03F 3/195

(54) **SYSTEMS AND METHODS FOR ANALOG FRONT-END (AFE) AMPLIFICATION WITH A COMPLEMENTARY BIAS-STAGE CIRCUIT**

(30) Priority: 26.11.2024 US 202463725412 P; 02.07.2025 US 202519258847
(71) Applicant: Samsung Electronics Co., Ltd., Suwon-si, Gyeonggi-do 16677 (KR)
(72) Inventor: PARK, Joung Won, San Jose, CA 95134 (US); BINAIE, Ali, San Jose, CA 95134 (US)
(74) Representative: Kuhnen & Wacker Patent- und Rechtsanwaltsbüro PartG mbB

(57) **Abstract**

An analog front-end, AFE, circuit includes a first-stage circuit including a first first-stage transistor including a first first-stage gate electrode connected to an input node of the AFE circuit, a first first-stage source electrode connected to a first supply-voltage node, and a first first-stage drain electrode connected to an output node of the AFE circuit, and a bias-stage circuit connected to the output node of the AFE circuit, the bias-stage circuit including a first bias-stage transistor including a first bias-stage gate electrode, a first bias-stage source electrode connected to the first supply-voltage node, and a first bias-stage drain electrode connected to the first bias-stage gate electrode, and a second bias-stage transistor including a second bias-stage gate electrode connected to the first bias-stage gate electrode, a second bias-stage source electrode connected to the first supply-voltage node, and a second bias-stage drain electrode connected to the output node of the AFE circuit.

## Description

### FIELD

Aspects of some embodiments of the present disclosure relate to systems and methods for analog front-end (AFE) amplification with a complementary bias-stage circuit.

### BACKGROUND

In the field of computers, a computing system may include multiple processing circuits connected to (e.g., communicatively coupled to) each other to perform various operations on data communicated between the multiple processing circuits. Each of the multiple processing circuits may correspond to a given die (e.g., to a given integrated circuit (IC) or chip), and the data may be communicated through die-to-die interfaces of the processing circuits. Such computing systems have become increasingly popular, in part, for allowing relatively complicated computations to be distributed (e.g., to be broken down into less complicated computations and distributed) among the processing circuits for more efficient processing of the data. Improvements to such processing circuits can improve overall system performance significantly.

The present background section is intended to provide context only, and the disclosure of any embodiment or concept in this section does not constitute an admission that said embodiment or concept is prior art.

### SUMMARY

Aspects of some embodiments of the present disclosure are directed to improved systems and methods for amplification of signals communicated between processing circuits (e.g., at a die-to-die interface between a first die (e.g., a first chip) configured to transmit a signal and a second die configured to receive the signal).

According to some embodiments of the present disclosure, there is provided an AFE circuit including a first-stage circuit including a first first-stage transistor including a first first-stage gate electrode connected to an input node of the AFE circuit, a first first-stage source electrode connected to a first supply-voltage node, and a first first-stage drain electrode connected to an output node of the AFE circuit, and a bias-stage circuit connected to the output node of the AFE circuit, the bias-stage circuit including a first bias-stage transistor including a first bias-stage gate electrode, a first bias-stage source electrode connected to the first supply-voltage node, and a first bias-stage drain electrode connected to the first bias-stage gate electrode, and a second bias-stage transistor including a second bias-stage gate electrode connected to the first bias-stage gate electrode, a second bias-stage source electrode connected to the first supply-voltage node, and a second bias-stage drain electrode connected to the output node of the AFE circuit.

The first bias-stage source electrode may be connected to the first supply-voltage node through a first metal-oxide-semiconductor (MOS) resistor.

The bias-stage circuit may further include a third bias-stage transistor including a third bias-stage gate electrode connected to a third supply-voltage node, a third bias-stage drain electrode connected to the first bias-stage drain electrode, and a third bias-stage source electrode connected to a second supply-voltage node.

The third bias-stage source electrode may be connected to the second supply-voltage node through a second metal-oxide-semiconductor (MOS) resistor.

The second bias-stage source electrode may be connected to the first supply-voltage node through a third metal-oxide-semiconductor (MOS) resistor.

The bias-stage circuit may further include a fourth bias-stage transistor including a fourth bias-stage gate electrode, a fourth bias-stage source electrode connected to a second supply-voltage node, and a fourth bias-stage drain electrode connected to the fourth bias-stage gate electrode, and a fifth bias-stage transistor including a fifth bias-stage gate electrode connected to the fourth bias-stage gate electrode, a fifth bias-stage source electrode connected to the second supply-voltage node, and a fifth bias-stage drain electrode connected to the output node of the AFE circuit.

The fourth bias-stage source electrode may be connected to the second supply-voltage node through a fourth metal-oxide-semiconductor (MOS) resistor.

The bias-stage circuit may further include a sixth bias-stage transistor including a sixth bias-stage gate electrode connected to a third supply-voltage node, a sixth bias-stage drain electrode connected to the fourth bias-stage drain electrode, and a sixth bias-stage source electrode connected to the first supply-voltage node.

The sixth bias-stage source electrode may be connected to the first supply-voltage node through a fifth metal-oxide-semiconductor (MOS) resistor.

The fifth bias-stage source electrode may be connected to the second supply-voltage node through a sixth metal-oxide-semiconductor (MOS) resistor.

The first-stage circuit may further include a second first-stage transistor including a second first-stage gate electrode connected to the first first-stage gate electrode, a second first-stage source electrode connected to a second supply-voltage node, and a second first-stage drain electrode connected to the first first-stage drain electrode.

The second first-stage source electrode may be connected to the second supply-voltage node through a first programmable capacitor and through a seventh metal-oxide-semiconductor (MOS) resistor.

The first first-stage source electrode may be connected to the first supply-voltage node through a second programmable capacitor and through an eighth metal-oxide-semiconductor (MOS) resistor.

The input node of the AFE circuit may be configured to receive a signal from a universal chiplet interconnect express (UCle) interface.

According to some other embodiments of the present disclosure, there is provided a device including a first processing circuit including a transmission circuit, and a second processing circuit connected to the first processing circuit via a communication channel, wherein the second processing circuit includes a first-stage circuit including a first first-stage transistor including a first first-stage gate electrode connected to an input node of the second processing circuit, a first first-stage source electrode connected to a first supply-voltage node, and a first first-stage drain electrode connected to an output node of the second processing circuit, and a bias-stage circuit connected to the output node of the second processing circuit, the bias-stage circuit including a first bias-stage transistor including a first bias-stage gate electrode, a first bias-stage source electrode connected to the first supply-voltage node, and a first bias-stage drain electrode connected to the first bias-stage gate electrode, and a second bias-stage transistor including a second bias-stage gate electrode connected to the first bias-stage gate electrode, a second bias-stage source electrode connected to the first supply-voltage node, and a second bias-stage drain electrode connected to the output node of the second processing circuit.

The first bias-stage source electrode may be connected to the first supply-voltage node through a first metal-oxide-semiconductor (MOS) resistor.

The bias-stage circuit may further include a third bias-stage transistor including a third bias-stage gate electrode connected to a third supply-voltage node, a third bias-stage drain electrode connected to the first bias-stage drain electrode, and a third bias-stage source electrode connected to a second supply-voltage node.

The third bias-stage source electrode may be connected to the second supply-voltage node through a second metal-oxide-semiconductor (MOS) resistor.

The second bias-stage source electrode may be connected to the first supply-voltage node through a third metal-oxide-semiconductor (MOS) resistor.

According to some other embodiments of the present disclosure, there is provided a method for signal amplification, the method including receiving, at an input node of a first-stage circuit of a first die, an input signal from a communication channel connecting the first die to a second die, and generating, by the first-stage circuit, an output voltage at an output node of the first die, the output node being connected to a bias-stage circuit that is configured to counteract an increase in a first supply voltage applied to a first supply-voltage terminal of the first die, the bias-stage circuit including a diode-connected device having a first gate terminal, a main-bias device having a second gate terminal connected to the first gate terminal, a first output terminal of the main-bias device being connected to the output node of the second die, and a first input terminal of the diode-connected device being connected to the first supply-voltage terminal, and an input-bias device having a second output terminal connected to the first gate terminal, and having a third gate terminal connected to a reference voltage, the reference voltage corresponding to a target common-mode voltage of the first die.

### BRIEF DESCRIPTION OF THE DRAWINGS

Non-limiting and non-exhaustive embodiments of the present disclosure are described with reference to the following figures, wherein like reference numerals refer to like parts throughout the various views unless otherwise specified.
FIG. 1A is a block diagram depicting a system for performing die-to-die communications, according to some embodiments of the present disclosure.
FIG. 1B is a block diagram depicting components of a transmitter and a receiver of the system for performing die-to-die communications depicted in FIG. 1A, according to some embodiments of the present disclosure.
FIG. 1C is a graph depicting relationships between voltage gain and frequency at different locations in a signal path associated with the transmitter and the receiver depicted in FIG. 1B, according to some embodiments of the present disclosure.
FIG. 1D is a graph depicting a relationship between a VDD drift (e.g., a drift in a value of a supply voltage) and a common-mode voltage (VCM) drift that is counteracted by (e.g., reduced or prevented by) an analog front-end (AFE) circuit of the receiver circuit depicted in FIG. 1B, according to some embodiments of the present disclosure.
FIG. 2 is a circuit schematic drawing depicting components of the AFE circuit depicted in FIG. 1B, according to some embodiments of the present disclosure.
FIG. 3A is a graph depicting experimental results for changes in common-mode voltages with respect to changes in VDD for five different combinations of devices, according to some embodiments of the present disclosure.
FIG. 3B is a graph depicting experimental results for changes in common-mode voltages with respect to changes in temperature for the five different combinations of devices, according to some embodiments of the present disclosure.
FIG. 4 is a flowchart depicting operations of a method for signal amplification, according to some embodiments of the present disclosure.

Corresponding reference characters indicate corresponding components throughout the several views of the drawings. Skilled artisans will appreciate that elements in the figures are illustrated for simplicity and clarity, and have not necessarily been drawn to scale. For example, the dimensions of some of the elements, layers, and regions in the figures may be exaggerated relative to other elements, layers, and regions to help to improve clarity and understanding of various embodiments. Also, common but well-understood elements and parts not related to the description of the embodiments might not be shown to facilitate a less obstructed view of these various embodiments and to make the description clear.

### DETAILED DESCRIPTION

Aspects of the present disclosure and methods of accomplishing the same may be understood more readily by reference to the detailed description of one or more embodiments and the accompanying drawings. Hereinafter, embodiments will be described in more detail with reference to the accompanying drawings. The described embodiments, however, may be embodied in various different forms, and should not be construed as being limited to only the illustrated embodiments herein. Rather, these embodiments are provided as examples so that this disclosure will be thorough and complete, and will fully convey aspects of the present disclosure to those skilled in the art. Accordingly, description of processes, elements, and techniques that are not necessary to those having ordinary skill in the art for a complete understanding of the aspects and features of the present disclosure may be omitted.

Unless otherwise noted, like reference numerals, characters, or combinations thereof denote like elements throughout the attached drawings and the written description, and thus, descriptions thereof will not be repeated. Skilled artisans will appreciate that elements in the figures are illustrated for simplicity and clarity, and have not necessarily been drawn to scale. For example, the dimensions of some of the elements, layers, and regions in the figures may be exaggerated relative to other elements, layers, and regions to help to improve clarity and understanding of various embodiments. Also, common but well-understood elements and parts not related to the description of the embodiments might not be shown to facilitate a less obstructed view of these various embodiments and to make the description clear.

In the detailed description, for the purposes of explanation, numerous specific details are set forth to provide a thorough understanding of various embodiments. It is apparent, however, that various embodiments may be practiced without these specific details or with one or more equivalent arrangements.

It will be understood that, although the terms "zeroth," "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present disclosure.

It will be understood that when an element or component is referred to as being "on," "connected to," or "coupled to" another element or component, it can be directly on, connected to, or coupled to the other element or component, or one or more intervening elements or components may be present. However, "directly connected/directly coupled" refers to one component directly connecting or coupling another component without an intermediate component. Meanwhile, other expressions describing relationships between components such as "between," "immediately between" or "adjacent to" and "directly adjacent to" may be construed similarly. In addition, it will also be understood that when an element or component is referred to as being "between" two elements or components, it can be the only element or component between the two elements or components, or one or more intervening elements or components may also be present.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof. As used herein, each of the terms "or" and "and/or" includes any and all combinations of one or more of the associated listed items. For example, the expression "A and/or B" denotes A, B, or A and B.

For the purposes of this disclosure, expressions such as "at least one of," when preceding a list of elements, modify the entire list of elements and do not modify the individual elements of the list. For example, "at least one of X, Y, or Z," "at least one of X, Y, and Z," and "at least one selected from the group consisting of X, Y, and Z" may be construed as X only, Y only, Z only, or any combination of two or more of X, Y, and Z, such as, for instance, XYZ, XYY, YZ, and ZZ.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

When one or more embodiments may be implemented differently, a specific process order may be performed differently from the described order. For example, two consecutively described processes may be performed substantially at the same time or performed in an order opposite to the described order.

Any of the components or any combination of the components described (e.g., in any system diagrams included herein) may be used to perform one or more of the operations of any flow chart included herein. Further, (i) the operations are merely examples, and may involve various additional operations not explicitly covered, and (ii) the temporal order of the operations may be varied.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random-access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the spirit and scope of the embodiments of the present disclosure.

Any of the functionalities described herein, including any of the functionalities that may be implemented with a host, a device, and/or the like or a combination thereof, may be implemented with hardware, software, firmware, or any combination thereof including, for example, hardware and/or software combinational logic, sequential logic, timers, counters, registers, state machines, volatile memories such as dynamic RAM (DRAM) and/or static RAM (SRAM), nonvolatile memory including flash memory, persistent memory such as cross-gridded nonvolatile memory, memory with bulk resistance change, phase change memory (PCM), and/or the like and/or any combination thereof, complex programmable logic devices (CPLDs), field programmable gate arrays (FPGAs), application-specific ICs (ASICs), central processing units (CPUs) including complex instruction set computer (CISC) processors and/or reduced instruction set computer (RISC) processors, graphics processing units (GPUs), neural processing units (NPUs), tensor processing units (TPUs), data processing units (DPUs), and/or the like, executing instructions stored in any type of memory. In some embodiments, one or more components may be implemented as a system-on-a- chip (SoC).

Any of the computational devices disclosed herein may be implemented in any form factor, such as 3.5 inch, 2.5 inch, 1.8 inch, M.2, Enterprise and Data Center Standard Form Factor (EDSFF), NF1, and/or the like, using any connector configuration such as Serial Advanced Technology Attachment (SATA), Small Computer System Interface (SCSI), Serial Attached SCSI (SAS), U.2, and/or the like. Any of the computational devices disclosed herein may be implemented entirely or partially with, and/or used in connection with, a server chassis, server rack, data room, data center, edge data center, mobile edge data center, and/or any combinations thereof.

Any of the devices disclosed herein that may be implemented as storage devices may be implemented with any type of nonvolatile storage media based on solid-state media, magnetic media, optical media, and/or the like. For example, in some embodiments, a storage device (e.g., a computational storage device) may be implemented as an SSD based on not-AND (NAND) flash memory, persistent memory such as cross-gridded nonvolatile memory, memory with bulk resistance change, PCM, and/or the like, or any combination thereof.

Any of the communication connections and/or communication interfaces disclosed herein may be implemented with one or more interconnects, one or more networks, a network of networks (e.g., the Internet), and/or the like, or a combination thereof, using any type of interface and/or protocol. Examples include Peripheral Component Interconnect Express (PCIe), non-volatile memory express (NVMe), NVMe-over-fabric (NVMe-oF), Ethernet, Transmission Control Protocol/Internet Protocol (TCP/IP), Direct Memory Access (DMA) Remote DMA (RDMA), RDMA over Converged Ethernet (ROCE), FibreChannel, InfiniBand, SATA, SCSI, SAS, Internet Wide Area RDMA Protocol (iWARP), and/or a coherent protocol, such as Compute Express Link (CXL), CXL.mem, CXL.cache, CXL.IO and/or the like, Gen-Z, Open Coherent Accelerator Processor Interface (OpenCAPI), Cache Coherent Interconnect for Accelerators (CCIX), and/or the like, Advanced eXtensible Interface (AXI), any generation of wireless network including 2G, 3G, 4G, 5G, 6G, and/or the like, any generation of Wi-Fi, Bluetooth, near-field communication (NFC), and/or the like, or any combination thereof.

In some embodiments, a software stack may include a communication layer that may implement one or more communication interfaces, protocols, and/or the like such as PCle, NVMe, CXL, Ethernet, NVMe-oF, TCP/IP, and/or the like, to enable a host and/or an application running on the host to communicate with a computational device or a storage device.

Each of the terms "processing circuit" and "means for processing" is used herein to mean any suitable combination of hardware, firmware, and software, employed to process data or digital signals. Processing circuit hardware may include, for example, application specific integrated circuits (ASICs), general purpose or special purpose central processing units (CPUs), digital signal processors (DSPs), graphics processing units (GPUs), and programmable logic devices such as field programmable gate arrays (FPGAs). In a processing circuit, as used herein, each function is performed either by hardware configured, i.e., hard-wired, to perform that function, or by more general-purpose hardware, such as a CPU, configured to execute instructions stored in a non-transitory storage medium. A processing circuit may be fabricated on a single printed circuit board (PCB) or distributed over several interconnected PCBs. A processing circuit may contain other processing circuits; for example, a processing circuit may include two processing circuits, an FPGA and a CPU, interconnected on a PCB.

Unless otherwise defined, all terms (including technical and scientific terms) used herein have the same meaning as commonly understood by one of ordinary skill in the art to which the present inventive concept belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

As mentioned above, in the field of computers, a computing system may include multiple processing circuits connected to (e.g., communicatively coupled to) each other to perform various operations on data communicated between the multiple processing circuits. Each of the multiple processing circuits may correspond to a given die (e.g., to a given IC or chip), and the data may be communicated through die-to-die interfaces of the processing circuits. Such computing systems have become increasingly popular, in part, for allowing relatively complicated computations to be distributed (e.g., to be broken down into less complicated computations and distributed) among the processing circuits for more efficient processing of the data. For example, in some embodiments, each processing circuit may be a processing unit for performing artificial intelligence- (Al-) related calculations (e.g., for performing vector calculations). For example, the processing circuits may include (e.g., may be) CPUs, GPUs, TPUs, and/or the like. Improvements to such processing circuits can improve overall system performance significantly. In some embodiments, the processing circuits may be interconnected via a communications channel (e.g., a wireline, such as a copper line). A voltage gain associated with signals received by a receiver (e.g., by a receiving portion) of a processing circuit may decrease as frequency increases. An AFE circuit may be utilized in the receiver to perform continuous time linear equalization (CTLE) to boost higher frequencies while not boosting noise. AFE circuits may be susceptible to VDD drift, temperature drift, and VDD noise. Temperature drift may cause device characteristics to change based on different device operating temperatures. VDD drift and temperature drift may cause a common-mode voltage to drift and may cause a duty cycle of input signals to drift. As used herein, a "common-mode voltage" refers to a middle voltage value (e.g., a middle point) between maximum and minimum voltage levels. For example, if a maximum voltage (e.g., VDD) is equal to 0.4 VDC and a minimum voltage (e.g., VSS) is equal to 0.0 VDC, the common-mode voltage may be equal to 0.2 VDC. That is, in some embodiments common-mode voltage may be equal to VDD divided by 2. However, one of ordinary skill in the art would understand that common-mode voltages are not limited to VDD divided by 2. For example, in some embodiments, if voltage swings from 100 mV to 280 mV, the common-mode voltage would be 190 mV, even if VDD is 400 mV.

Conventional CTLE circuits may exhibit a variety of problems such as having nonlinear device characteristics, having high noise, and having high power consumption.

Aspects of some embodiments of the present disclosure provide for an improved AFE circuit in the first stage of a receiver (Rx) (e.g., a universal chiplet interconnect express (UCle) Rx) that utilizes a complementary bias-stage circuit to counteract VDD drift, temperature drift, and VDD noise while consuming a relatively small area and having a relatively low power consumption. Aspects of embodiments of the present disclosure may provide for an improved AFE circuit with low VDD sensitivity and low temperature sensitivity.

Aspects of some embodiments of the present disclosure provide for improved AFE circuits capable of maintaining a 50% duty cycle for a variable transmitter (Tx) VDD. For example, different Tx VDDs may result in different common-mode levels for a data signal at the input of the AFE. Aspects of embodiments of the present disclosure provide for AFE circuits having improved stability with different Tx VDDs and different common-mode levels.

Aspects of some embodiments of the present disclosure provide for an improved AFE circuit with a built-in linear CTLE to compensate for channel loss between the Tx and Rx while having a low jitter, consuming a small area, consuming low power, having low VDD sensitivity, and having low temperature sensitivity.

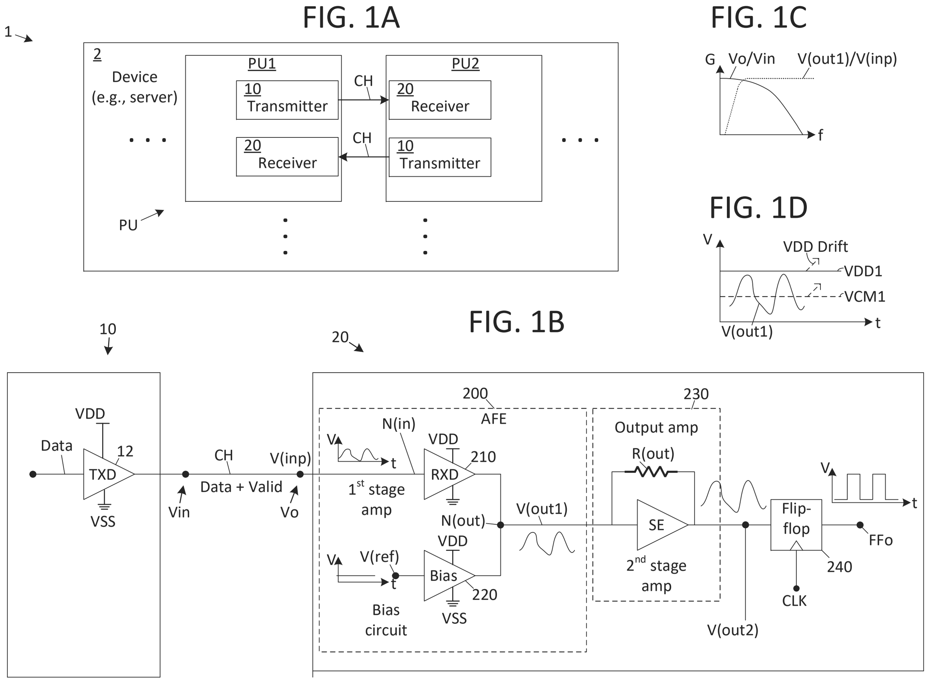

FIG. 1A is a block diagram depicting a system 1 for performing die-to-die communications, according to some embodiments of the present disclosure.

Referring to FIG. 1A, the system 1 may include a device 2 (e.g., a server, a computer, a mobile device, and/or the like). The device 2 may include processing units PU (e.g., PU1 and PU2). For example, the processing units may include (e.g., may be) CPUs, GPUs, TPUs, and/or the like. Each processing unit PU may include a transmitter 10 (e.g., a UCle transmitter) and/or a receiver 20 (e.g., a UCle receiver). As used herein, UCle refers to a type of die-to-die interface for transmitting signals (e.g., data) between dies in a manner that may consume less power and may be more easily scaled than other types of interfaces. Although the present disclosure refers to UCle (e.g., a UCle protocol), it should be understood that the present disclosure is not limited thereto. For example, aspects of embodiments of the present disclosure may be useful for any suitable short-range applications, and, as such, may also be suitable for use with an advanced interface bus protocol, a high bandwidth interconnect protocol, and/or the like.

A given transmitter 10 may be connected to a given receiver 20 via a communication channel CH. A given signal transmitted over the communication channel CH may be received at the receiver 20 with some signal loss. For example, the signal may be received by the receiver 20 with more attenuation of some frequencies than other frequencies (e.g., high frequencies may be attenuated more than lower frequencies).

FIG. 1B is a block diagram depicting components of the transmitter 10 and the receiver 20 of the system 1 for performing die-to-die communications depicted in FIG. 1A, according to some embodiments of the present disclosure.

FIG. 1C is a graph depicting relationships between voltage gain and frequency at different locations in a signal path associated with the transmitter 10 and the receiver 20 depicted in FIG. 1B, according to some embodiments of the present disclosure.

FIG. 1D is a graph depicting a relationship between a VDD drift (e.g., a drift in a value of a supply voltage) and a common-mode voltage (VCM) drift that is counteracted by (e.g., reduced or prevented by) an analog front-end (AFE) circuit 200 of the receiver 20 depicted in FIG. 1B, according to some embodiments of the present disclosure.

Referring to FIG. 1B, aspects of some embodiments of the present disclosure allow for the receiver 20 to include the AFE circuit 200, as an improved AFE circuit design, to generate an equalized output with improved stability, with relatively low power consumption and by consuming less area than some other AFE circuits.

In some embodiments, the AFE circuit 200 may receive a receiver input signal V(inp) (e.g., an input voltage signal) from a transmitter circuit 12. The transmitter circuit 12 may amplify data provided to its input and send the data (e.g., valid data), as transmit data (TXD), to the AFE circuit 200 via the channel CH.

Referring to FIG. 1B and FIG. 1C, a ratio of a channel output voltage Vo and a channel input voltage Vin (e.g., a voltage gain G of the communication channel CH) may be plotted in a graph, as in FIG. 1C, to depict how the voltage gain G may be attenuated (e.g., may be reduced) more at higher frequencies (f) than at lower frequencies. The AFE circuit 200 may include an input amplification-stage circuit 210 (which may also be referred to as a "first-stage circuit") to perform equalization (e.g., to perform CTLE) such that the higher frequencies are boosted to compensate for the attenuation from the communication channel CH, such that a plot of a ratio of a first output V(out1) from the input amplification-stage circuit 210 and the receiver input signal V(inp) (e.g., a voltage gain G of the input amplification-stage circuit 210) may appear as a high-pass filter. For example, the first output V(out1) may be measured at an output node N(out) of the AFE circuit 200, and the receiver input signal V(inp) may be measured at an input node N(in) of the AFE circuit 200.

Referring to FIG. 1B and FIG. 1D, The AFE circuit 200 may experience a supply-voltage drift (e.g., a VDD drift) causing a common-mode voltage VCM of the AFE circuit 200 to follow the supply-voltage drift. For example, if the VDD level increases, the common-mode voltage VCM may also increase. If the VDD level decreases, the common-mode voltage may also decrease. Additionally, the supply-voltage drift (e.g., the VDD drift) may cause a duty cycle of the first output V(out1) from the input amplification-stage circuit 210 to drift. For example, the duty cycle of the first output V(out1) may drift anywhere from less than 10% to 50% or 70%.

In some embodiments, a bias-stage circuit 220 may be provided with a reference voltage Vref as an input and with an output connected to the output node N(out) of the AFE circuit 200 to counteract the supply-voltage drift. In some embodiments, the reference voltage Vref may correspond to a target common-mode voltage VCM. For example, the reference voltage Vref may be determined based on a common-mode voltage VCM of the transmitter circuit 12. As discussed in further detail below, the bias-stage circuit 220 may generate a change in the first output V(out1) that is opposite to (e.g., that counteracts) a change in the first output V(out1) caused by a supply-voltage drift or caused by a change in temperature. For example, as VDD increases and causes the common-mode voltage VCM to increase, the bias-stage circuit 220 may cause a decrease in the common-mode voltage VCM level, such that a change in the common-mode is canceled out by the output from the bias-stage circuit 220. Additionally, the bias-stage circuit 220 may reduce a supply-voltage noise level. Accordingly, the AFE circuit 200 may provide an equalized output (based on the input amplification-stage circuit 210) with improved stability (based on the bias-stage circuit 220).

Referring still to FIG. 1B, the first output V(out1) may be sent to a second-stage amplification circuit 230 for further amplification to generate a second output V(out2) from the second-stage amplification circuit 230. The second output V(out2)) may be sent to a flip-flop circuit 240 to generate a flip-flop output FFo including a digitized version of the second output V(out2). The flip-flop circuit 240 may operate based on receiving a clock signal CLK. The flip-flop output FFo may be sent to other components of a given processing unit PU for further processing of the receive data RXD (e.g., the data received by the input amplification-stage circuit 210 may be referred to as receive data RXD).

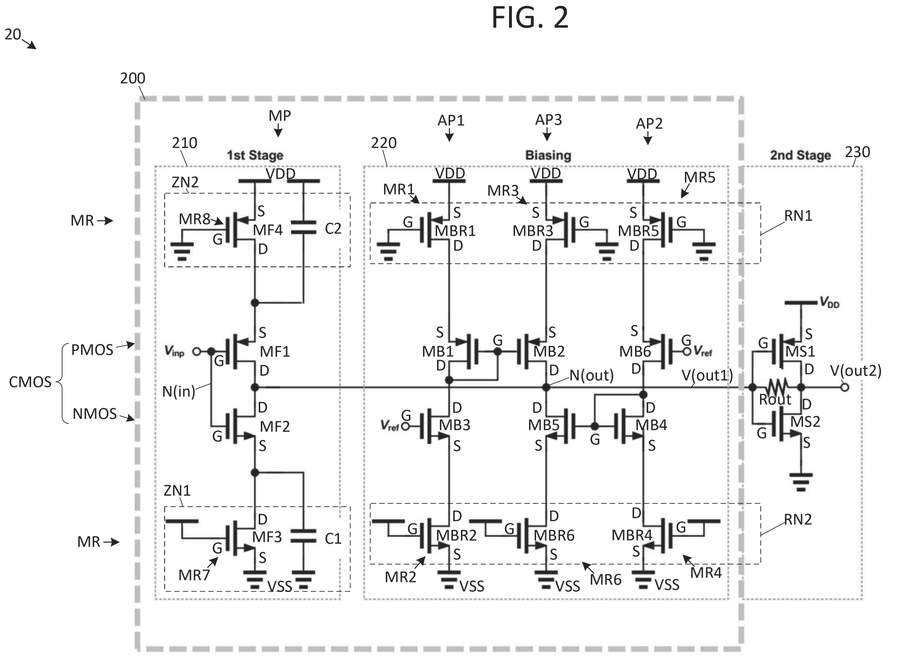

FIG. 2 is a circuit schematic drawing depicting components of the AFE circuit 200 depicted in FIG. 1B, according to some embodiments of the present disclosure.

Referring to FIG. 2, and as discussed above, the receiver 20 may include the AFE circuit 200 and the second-stage amplification circuit 230. In some embodiments, the AFE circuit 200 may include the input amplification-stage circuit 210, which may include (e.g., may be) a single-ended (SE) complementary metal-oxide-semiconductor (CMOS) input amplification-stage circuit. For example, the input amplification-stage circuit 210 may include p-channel MOS (PMOS) and n-channel MOS (NMOS) components, which may cooperate to form the CMOS input amplification-stage circuit 210. The AFE circuit 200 may include the bias-stage circuit 220. The bias-stage circuit 220 may include PMOS and NMOS components, which may cooperate to form a CMOS bias-stage circuit 220.

In some embodiments, the input node N(in) of the AFE circuit 200 may receive the receiver input signal V(inp) from the communication channel CH (see FIG. 1B). In some embodiments, the output node N(out) of the AFE circuit 200 may connect the output of the input amplification-stage circuit 210 with the output of the bias-stage circuit 220 and with the input of the second-stage amplification circuit 230.

In some embodiments, the input amplification-stage circuit 210 may include (e.g., may be) a single-ended CMOS type input stage. For example, a first first-stage transistor MF1 of the input amplification-stage circuit 210 may be connected with a second first-stage transistor MF2 of the input amplification-stage circuit 210. In some embodiments, the first first-stage transistor MF1 may be a PMOS transistor and the second first-stage transistor MF2 may be an NMOS transistor. A first first-stage gate electrode (G) of the first first-stage transistor MF1 may be connected to a second first-stage gate electrode (G) of the second first-stage transistor MF2. A first first-stage drain electrode (D) of the first first-stage transistor MF1 may be connected to a second first-stage drain electrode (D) of the second first-stage transistor MF2. The gate electrodes (G) of the first first-stage transistor MF1 and of the second first-stage transistor MF2 may be connected to the input node N(in) of the AFE circuit 200. The drain electrodes (D) of the first first-stage transistor MF1 and of the second first-stage transistor MF2 may be connected to the output node N(out) of the AFE circuit 200. The source electrodes (S) of the first first-stage transistor MF1 and of the second first-stage transistor MF2 may be connected to respective impedance network components (e.g., a first impedance network ZN1 and a second impedance network ZN2).

The first impedance network ZN1 and the second impedance network ZN2 may provide source degeneration impedances for performing the CTLE function. The first impedance network ZN1 may include a third first-stage transistor MF3 and a first capacitor C1 (e.g., a programmable capacitor). The second impedance network ZN2 may include a fourth first-stage transistor MF4 and a second capacitor C2 (e.g., a programmable capacitor).

The third first-stage transistor MF3 may be configured as a MOS resistor MR (e.g., as a seventh MOS resistor MR7) having: a third first-stage gate electrode (G) connected to the first supply voltage (e.g., VDD); a third first-stage source electrode (S) connected to the second supply voltage (e.g., VSS); and a third first-stage drain electrode (D) connected to both a second first-stage source electrode (S) of the second first-stage transistor MF2 and to a first terminal of the first capacitor C1. A second terminal of the first capacitor C1 may be connected to the second supply voltage (e.g., VSS).

The fourth first-stage transistor MF4 may be configured as a MOS resistor MR (e.g., as an eighth MOS resistor MR8) having: a fourth first-stage gate electrode (G) connected to the second supply voltage (e.g., VSS); a fourth first-stage source electrode (S) connected to the first supply voltage (e.g., VDD); and a fourth first-stage drain electrode (D) connected to both a first first-stage source electrode (S) of the first first-stage transistor MF1 and to a first terminal of the second capacitor C2. A second terminal of the second capacitor C2 may be connected to the first supply voltage (e.g., VDD).

In some embodiments, the bias-stage circuit 220 may include a first MOS resistor network RN1 and a second MOS resistor network RN2. For example, the first MOS resistor network RN1 may include three MOS resistors (e.g., MR1, MR3, and MR5) configured from three PMOS transistors (e.g., a first bias-stage resistor/transistor MBR1, a third bias-stage resistor/transistor MBR3, and a fifth bias-stage resistor/transistor MBR5). The three MOS resistors MR1, MR3, and MR5 may each have a gate electrode (G) connected to the second supply voltage (e.g., VSS), a source electrode (S) connected to the first supply voltage (e.g., VDD), and a drain electrode (D) connected to a respective one of three transistors (e.g., a first bias-stage transistor MB1, a second bias-stage transistor MB2, and a sixth bias-stage transistor MB6).

The second MOS resistor network RN2 may include three MOS resistors (e.g., MR2, MR4, and MR6) configured from three NMOS transistors (e.g., a second bias-stage resistor/transistor MBR2, a fourth bias-stage resistor/transistor MBR4, and a sixth bias-stage resistor/transistor MBR6). The three MOS resistors MR2, MR4, and MR6 may each have a gate electrode (G) connected to the first supply voltage (e.g., VDD), a source electrode (S) connected to the second supply voltage (e.g., VSS), and a drain electrode (D) connected to a respective one of three transistors (e.g., a third bias-stage transistor MB3, a fourth bias-stage transistor MB4, and a fifth bias-stage transistor MB5).

In some embodiments, the bias-stage circuit 220 may include six bias-stage transistors (e.g., the first bias-stage transistor MB1, the second bias-stage transistor MB2, the third bias-stage transistor MB3, the fourth bias-stage transistor MB4, the fifth bias-stage transistor MB5, and the sixth bias-stage transistor MB6) connected to respective ones of the first MOS resistor network RN1 and the second MOS resistor network RN2 and configured to counteract VDD drift, as discussed above.

In some embodiments, the first bias-stage transistor MB1 may include a first bias-stage gate electrode (G), a first bias-stage source electrode (S) connected to the first supply voltage (e.g., VDD) (e.g., via a first supply-voltage node), and a first bias-stage drain electrode (D) connected to the first bias-stage gate electrode (G). That is, the first bias-stage transistor MB1 may be configured to operate as a diode-connected transistor having a same voltage at the first bias-stage drain electrode (D) and at the first bias-stage gate electrode (G). The first bias-stage transistor MB1 may be connected to the first supply voltage (e.g., VDD) through the MOS resistors MR1. For example, the first bias-stage source electrode (S) may be connected to the drain electrode (D) of the MOS resistor MR1, and the source terminal (S) of the MOS resistor MR1 may be connected to the first supply voltage (e.g., VDD).

In some embodiments, the second bias-stage transistor MB2 may include a second bias-stage gate electrode (G) connected to the first bias-stage gate electrode (G), a second bias-stage source electrode (S) connected to the first supply-voltage node (e.g., VDD), and a second bias-stage drain electrode (D) connected to the output node N(out) of the AFE circuit 200. The second bias-stage transistor MB2 may be connected to the first supply voltage (e.g., VDD) through the MOS resistor MR3. For example, the second bias-stage source electrode (S) may be connected to the drain electrode (D) of the MOS resistor MR3, and the source terminal (S) of the MOS resistor MR3 may be connected to the first supply voltage (e.g., VDD).

In some embodiments, the third bias-stage transistor MB3 may include a third bias-stage gate electrode (G) connected to a third supply-voltage node (e.g., to the reference voltage Vref), a third bias-stage drain electrode (D) connected to the first bias-stage drain electrode (D) (of the first bias-stage transistor MB1) and a third bias-stage source electrode (S) connected to a second supply-voltage node (e.g., VSS) through the MOS resistor MR2. For example, the third bias-stage source electrode (S) may be connected to the drain electrode (D) of the MOS resistor MR2, and the source terminal (S) of the MOS resistor MR2 may be connected to the second supply voltage (e.g., VSS).

In some embodiments, the fourth bias-stage transistor MB4 may include a fourth bias-stage gate electrode (G), a fourth bias-stage source electrode (S) connected to the second supply voltage (e.g., VSS) (e.g., via a second supply-voltage node), and a fourth bias-stage drain electrode (D) connected to the fourth bias-stage gate electrode (G). That is, the fourth bias-stage transistor MB4 may be configured to operate as a diode-connected transistor having a same voltage at the fourth bias-stage drain electrode (D) and at the fourth bias-stage gate electrode (G). The fourth bias-stage transistor MB4 may be connected to the second supply voltage (e.g., VSS) through the MOS resistors MR4. For example, the fourth bias-stage source electrode (S) may be connected to the drain electrode (D) of the MOS resistor MR4, and the source terminal (S) of the MOS resistor MR4 may be connected to the second supply voltage (e.g., VSS).

In some embodiments, the fifth bias-stage transistor MB5 may include a fifth bias-stage gate electrode (G) connected to the fourth bias-stage gate electrode (G), a fifth bias-stage source electrode (S) connected to the second supply-voltage node (e.g., VSS), and a fifth bias-stage drain electrode (D) connected to the output node N(out) of the AFE circuit 200. The fifth bias-stage transistor MB5 may be connected to the second supply voltage (e.g., VSS) through the MOS resistor MR6. For example, the fifth bias-stage source electrode (S) may be connected to the drain electrode (D) of the MOS resistor MR6, and the source terminal (S) of the MOS resistor MR6 may be connected to the second supply voltage (e.g., VSS).

In some embodiments, the sixth bias-stage transistor MB6 may include a sixth bias-stage gate electrode (G) connected to the third supply-voltage node (e.g., to the reference voltage Vref), a sixth bias-stage drain electrode (D) connected to the fourth bias-stage drain electrode (D) (of the fourth bias-stage transistor MB4) and a sixth bias-stage source electrode (S) connected to a first supply-voltage node (e.g., VDD) through the MOS resistor MR5. For example, the sixth bias-stage source electrode (S) may be connected to the drain electrode (D) of the MOS resistor MR5, and the source terminal (S) of the MOS resistor MR5 may be connected to the first supply voltage (e.g., VDD).

In some embodiments, the output node N(out) of the AFE circuit 200 may be connected to an input of the second-stage amplification circuit 230. For example, the input of the second-stage amplification circuit 230 may be a node connecting a first second-stage gate electrode (G) of a first second-stage transistor MS1 to a second second-stage gate electrode (G) of a second second-stage transistor MS2. A first second-stage drain electrode (D) of the first second-stage transistor MS1 may be connected to a second second-stage drain electrode (D) of the second second-stage transistor MS2. A first second-stage source electrode (S) of the first second-stage transistor MS1 may be connected to the first supply voltage (e.g., VDD). A second second-stage source electrode (S) of the second second-stage transistor MS2 may be connected to the second supply voltage (e.g., VSS). An output resistor Rout may be connected from the input of the second-stage amplification circuit 230 to the drain electrodes (D) of the first second-stage transistor MS1 and of the second second-stage transistor MS2, which may correspond to a second output V(out2) from the second-stage amplification circuit 230.

The first bias-stage transistor MB1 and the fourth bias-stage transistor MB4 may be referred to as diode-connected devices. The third bias-stage transistor MB3 and the sixth bias-stage transistor MB6 may be referred to as input-bias devices. The second bias-stage transistor MB2 and the fifth bias-stage transistor MB5 may be referred to as main-bias devices. The source terminals of the devices may be referred to as input terminals. The drain terminals of the devices may be referred to as output terminals. The interactions between the diode-connected devices (e.g., MB1 and MB4) and their respective main-bias devices (e.g., MB2 and MB5) and input-bias devices (e.g., MB3 and MB6) caused by a change in the first supply voltage (e.g., caused by a VDD drift) may cause the common-mode voltage VCM at the output node N(out) to remain stable.

For example, if the first supply voltage (e.g., VDD) increases, then a voltage at the first bias-stage drain electrode (D) may increase. Because the first bias-stage drain electrode (D) is connected to the second bias-stage gate electrode (G), a voltage at the second bias-stage gate electrode (G) may increase. If the voltage at the second bias-stage gate electrode (G) increases, a voltage at the second bias-stage drain electrode (D) may decrease, which may prevent the common-mode voltage VCM at the output node N(out) from following the increase in the first supply voltage (e.g., VDD). If the first supply voltage (e.g., VDD) decreases, then the voltage at the first bias-stage drain electrode (D) may decrease. Because the first bias-stage drain electrode (D) is connected to the second bias-stage gate electrode (G), the voltage at the second bias-stage gate electrode (G) may decrease. If the voltage at the second bias-stage gate electrode (G) decreases, the voltage at the second bias-stage drain electrode (D) may increase, which may prevent the common-mode voltage VCM at the output node N(out) from following the decrease in the first supply voltage (e.g., VDD).

Similarly, and in a complementary manner, if the first supply voltage (e.g., VDD) increases, then a voltage at the fourth bias-stage drain electrode (D) may increase. Because the fourth bias-stage drain electrode (D) is connected to the fifth bias-stage gate electrode (G), a voltage at the fifth bias-stage gate electrode (G) may increase. If the voltage at the fifth bias-stage gate electrode (G) increases, a voltage at the fifth bias-stage drain electrode (D) may decrease, which may prevent the common-mode voltage VCM at the output node N(out) from following the increase in the first supply voltage (e.g., VDD). If the first supply voltage (e.g., VDD) decreases, then the voltage at the fourth bias-stage drain electrode (D) may decrease. Because the fourth bias-stage drain electrode (D) is connected to the fifth bias-stage gate electrode (G), the voltage at the fifth bias-stage gate electrode (G) may decrease. If the voltage at the fifth bias-stage gate electrode (G) decreases, the voltage at the fifth bias-stage drain electrode (D) may increase, which may prevent the common-mode voltage VCM at the output node N(out) from following the decrease in the first supply voltage (e.g., VDD).

The components of auxiliary paths AP1, AP2, and AP3 may be used as VDD/temperature stabilizers, instead of being used to create two differential amplifiers along with the first-stage components (as in some conventional approaches). As such, the area of the AFE circuit 200 may be reduced when compared to other AFE circuits. The auxiliary Vref paths (e.g., AP1 and AP2) may be implemented using smaller device sizes due to a lower current flow through the Vref paths. Additionally, noise (e.g., significant noise) from bias-stage devices may be source degenerated due to being matched with the main path MP.

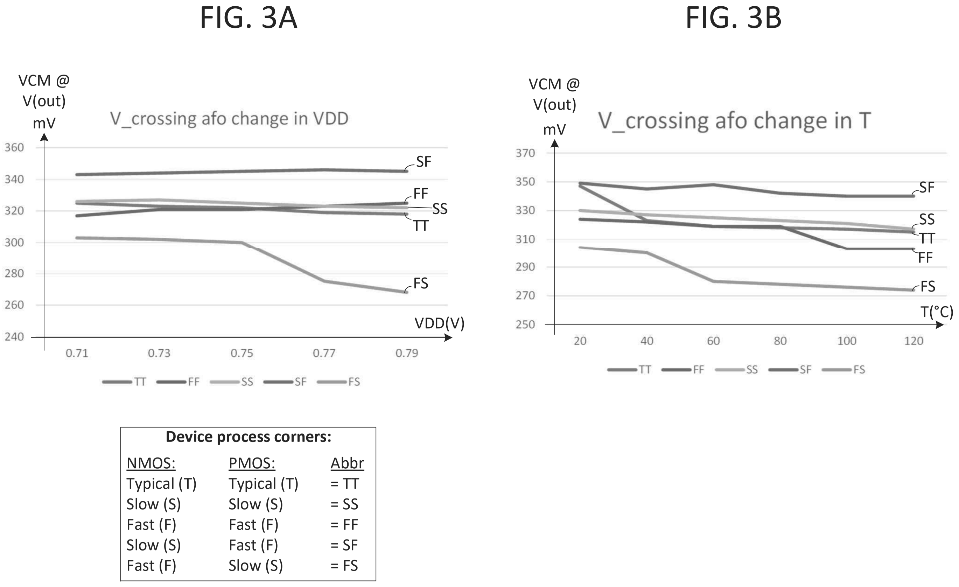

FIG. 3A is a graph depicting experimental results for changes in common-mode voltages with respect to changes in VDD for five different combinations of devices, according to some embodiments of the present disclosure.

Referring to FIG. 3A, the five different combinations of devices (e.g., the device process corners) evaluated under experimentation included: a first pairing TT including a typical NMOS transistor and a typical PMOS transistor; a second pairing FF including a fast NMOS transistor and a fast PMOS transistor; a third pairing SS including a slow NMOS transistor and a slow PMOS transistor; a fourth pairing SF including a slow NMOS transistor and a fast PMOS transistor; and a fifth pairing FS including a fast NMOS transistor and a slow PMOS transistor.

The first pairing TT, the second pairing FF, and the third pairing SS resulted in a common-mode voltage VCM ranging from about 320 mV to about 330 mV based on a change in VDD ranging from about 0.71 V to about 0.79 V. The fourth pairing SF resulted in the common-mode voltage VCM ranging from about 340 mV to about 350 mV based on a change in VDD ranging from about 0.71 V to about 0.79 V. The fifth pairing FS resulted in the common-mode voltage VCM ranging from about 300 mV to about 270 mV based on a change in VDD ranging from about 0.71 V to about 0.79 V. Aspects of embodiments of the present disclosure provided for a zero-crossing voltage varying less than 10 mV based on VDD changing from 0.71 V to 0.79 V. Additionally, only for the FS corner, did the zero-crossing voltage change by 30 mV at higher VDD.

FIG. 3B is a graph depicting experimental results for changes in common-mode voltages with respect to changes in temperature for the five different combinations of devices, according to some embodiments of the present disclosure.

Referring to FIG. 3B, the five different combinations of devices (e.g., the device process corners) evaluated under experimentation included: a first pairing TT including a typical NMOS transistor and typical PMOS transistor; a second pairing FF including a fast NMOS transistor and a fast PMOS transistor; a third pairing SS including a slow NMOS transistor and a slow PMOS transistor; a fourth pairing SF including a slow NMOS transistor and a fast PMOS transistor; and a fifth pairing FS including a fast NMOS transistor and a slow PMOS transistor.

The first pairing TT, the second pairing FF, and the third pairing SS resulted in a common-mode voltage VCM ranging from about 350 mV to about 300 mV based on a change in temperature (in degrees Celsius) ranging from about 20°C to about 120°C. The fourth pairing SF resulted in the common-mode voltage VCM ranging from about 350 mV to about 340 mV based on a change in temperature (in degrees Celsius) ranging from about 20°C to about 120°C. The fifth pairing FS resulted in the common-mode voltage VCM ranging from about 310 mV to about 270 mV based on a change in temperature (in degrees Celsius) ranging from about 20°C to about 120°C. In summation, aspects of embodiments of the present disclosure provided for a stable zero-crossing versus temperature.

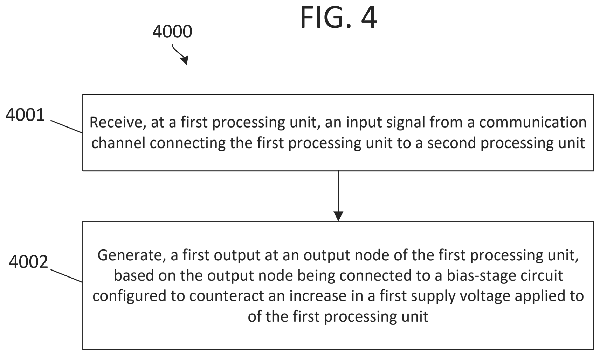

FIG. 4 is a flowchart depicting operations of a method 4000 for signal amplification, according to some embodiments of the present disclosure.

Referring to FIG. 4, the method 4000 may include one or more of the following operations. An input node N(in) of an input amplification-stage circuit 210 (e.g., a single-ended CMOS input amplification-stage circuit) of a first processing unit PU (e.g., a first die) may receive an input signal (e.g., a receiver input signal V(inp)) from a communication channel CH connecting the first processing unit PU to a second processing unit PU (e.g., a second die) (operation 4001). The input amplification-stage circuit 210 may generate a first output V(out1) at an output node N(out) of the first processing unit PU (operation 4002). The output node N(out) may be connected to a bias-stage circuit 220 that is configured to counteract an increase in a first supply voltage (e.g., VDD) applied to a first supply-voltage terminal of the first processing unit PU.

Accordingly, aspects of some embodiments of the present disclosure may provide improvements to AFE circuits by providing for several advantages, including: providing single-ended amplification while having the advantages of differential amplification, without the drawbacks of differential amplification; maintaining robust operation in the presence of temperature and voltage supply (e.g., VDD) variations; consuming less power compared to differential amplifiers; outputting less noise compared to differential amplifiers; maintaining a 50% duty cycle at the output in the presence of wide input common-mode change; providing built-in linear CTLE, without burning (e.g., without consuming) extra power; and consuming a relatively small die area (e.g., compared to differential amplifiers).

Example embodiments of the disclosure may extend to the following statements, without limitation:

Statement 1. An example method includes: receiving, at an input node of a first-stage circuit of a first die, an input signal from a communication channel connecting the first die to a second die, and generating, by the first-stage circuit, an output voltage at an output node of the first die, the output node being connected to a bias-stage circuit that is configured to counteract an increase in a first supply voltage applied to a first supply-voltage terminal of the first die.

Statement 2. An example system for performing the method of statement 1 includes the first-stage circuit, the first-stage circuit including a first first-stage transistor including a first first-stage gate electrode connected to an input node of the first die, a first first-stage source electrode connected to the first supply-voltage terminal, and a first first-stage drain electrode connected to an output node of the first die, and the bias-stage circuit connected to the output node of the first die, the bias-stage circuit including a first bias-stage transistor including a first bias-stage gate electrode, a first bias-stage source electrode connected to the first supply-voltage terminal, and a first bias-stage drain electrode connected to the first bias-stage gate electrode, and a second bias-stage transistor including a second bias-stage gate electrode connected to the first bias-stage gate electrode, a second bias-stage source electrode connected to the first supply-voltage terminal, and a second bias-stage drain electrode connected to the output node of the AFE circuit.

While embodiments of the present disclosure have been particularly shown and described with reference to the embodiments described herein, it will be understood by those of ordinary skill in the art that various changes in form and details may be made therein without departing from scope of the present disclosure as set forth in the following claims.

## Claims

1. An analog front-end, AFE, circuit comprising:
a first-stage circuit comprising a first first-stage transistor comprising a first first-stage gate electrode connected to an input node of the AFE circuit, a first first-stage source electrode connected to a first supply-voltage node, and a first first-stage drain electrode connected to an output node of the AFE circuit; and
a bias-stage circuit connected to the output node of the AFE circuit, the bias-stage circuit comprising:
a first bias-stage transistor comprising a first bias-stage gate electrode, a first bias-stage source electrode connected to the first supply-voltage node, and a first bias-stage drain electrode connected to the first bias-stage gate electrode; and
a second bias-stage transistor comprising a second bias-stage gate electrode connected to the first bias-stage gate electrode, a second bias-stage source electrode connected to the first supply-voltage node, and a second bias-stage drain electrode connected to the output node of the AFE circuit.

2. The AFE circuit of claim 1, wherein the first bias-stage source electrode is connected to the first supply-voltage node through a first metal-oxide-semiconductor, MOS, resistor.

3. The AFE circuit of claim 1 or 2, wherein the bias-stage circuit further comprises a third bias-stage transistor comprising a third bias-stage gate electrode connected to a third supply-voltage node, a third bias-stage drain electrode connected to the first bias-stage drain electrode, and a third bias-stage source electrode connected to a second supply-voltage node.

4. The AFE circuit of claim 3, wherein the third bias-stage source electrode is connected to the second supply-voltage node through a second metal-oxide-semiconductor, MOS, resistor.

5. The AFE circuit of any one of claims 1 to 4, wherein the second bias-stage source electrode is connected to the first supply-voltage node through a third metal-oxide-semiconductor, MOS, resistor.

6. The AFE circuit of any one of claims 1 to 5, wherein the bias-stage circuit further comprises:
a fourth bias-stage transistor comprising a fourth bias-stage gate electrode, a fourth bias-stage source electrode connected to a second supply-voltage node, and a fourth bias-stage drain electrode connected to the fourth bias-stage gate electrode; and
a fifth bias-stage transistor comprising a fifth bias-stage gate electrode connected to the fourth bias-stage gate electrode, a fifth bias-stage source electrode connected to the second supply-voltage node, and a fifth bias-stage drain electrode connected to the output node of the AFE circuit.

7. The AFE circuit of claim 6, wherein the fourth bias-stage source electrode is connected to the second supply-voltage node through a fourth metal-oxide-semiconductor, MOS, resistor.

8. The AFE circuit of claim 6 or 7, wherein the bias-stage circuit further comprises a sixth bias-stage transistor comprising a sixth bias-stage gate electrode connected to a third supply-voltage node, a sixth bias-stage drain electrode connected to the fourth bias-stage drain electrode, and a sixth bias-stage source electrode connected to the first supply-voltage node.

9. The AFE circuit of claim 8, wherein the sixth bias-stage source electrode is connected to the first supply-voltage node through a fifth metal-oxide-semiconductor, MOS, resistor.

10. The AFE circuit of any one of claims 6 to 9, wherein the fifth bias-stage source electrode is connected to the second supply-voltage node through a sixth metal-oxide-semiconductor, MOS, resistor.

11. The AFE circuit of any one of claims 1 to 10, wherein the first-stage circuit further comprises a second first-stage transistor comprising a second first-stage gate electrode connected to the first first-stage gate electrode, a second first-stage source electrode connected to a second supply-voltage node, and a second first-stage drain electrode connected to the first first-stage drain electrode.

12. The AFE circuit of claim 11, wherein the second first-stage source electrode is connected to the second supply-voltage node through a first programmable capacitor and through a seventh metal-oxide-semiconductor, MOS, resistor.

13. The AFE circuit of any one of claims 1 to 12, wherein the first first-stage source electrode is connected to the first supply-voltage node through a second programmable capacitor and through an eighth metal-oxide-semiconductor, MOS, resistor.

14. The AFE circuit of any one of claims 1 to 13, wherein the input node of the AFE circuit is configured to receive a signal from a universal chiplet interconnect express, UCle, interface.

15. A device comprising:
a first processing circuit comprising a transmission circuit; and
a second processing circuit connected to the first processing circuit via a communication channel, wherein the second processing circuit is the AFE circuit according to any one of the preceding claims.

## Amended claims

### Amended claims in accordance with Rule 137(2) EPC.

1. An analog front-end, AFE, circuit comprising:
a first-stage circuit (210) comprising a first first-stage transistor (MF1) comprising a first first-stage gate electrode (G) connected to an input node (N(in)) of the AFE circuit (200), a first first-stage source electrode (S) connected to a first supply-voltage node (VDD), and a first first-stage drain electrode (D) connected to an output node (N(out)) of the AFE circuit (200); and
a bias-stage circuit (220), and
**characterized in that**
the bias-stage circuit (220) is connected to the output node (N(out)) of the AFE circuit (200),
the bias-stage circuit (220) comprises:
a first bias-stage transistor (MB1) comprising a first bias-stage gate electrode (G), a first bias-stage source electrode (S) connected to the first supply-voltage node (VDD), and a first bias-stage drain electrode (D) connected to the first bias-stage gate electrode (G); and
a second bias-stage transistor (MB2) comprising a second bias-stage gate electrode (G) connected to the first bias-stage gate electrode (G), a second bias-stage source electrode (S) connected to the first supply-voltage node (VDD), and a second bias-stage drain electrode (D) connected to the output node (N(out)) of the AFE circuit (200).

2. The AFE circuit of claim 1, wherein the first bias-stage source electrode (S) is connected to the first supply-voltage node (VDD) through a first metal-oxide-semiconductor, MOS, resistor (MR1).

3. The AFE circuit of claim 1 or 2, wherein the bias-stage circuit (220) further comprises a third bias-stage transistor (MB3) comprising a third bias-stage gate electrode (G) connected to a third supply-voltage node (Vref), a third bias-stage drain electrode (D) connected to the first bias-stage drain electrode (D), and a third bias-stage source electrode (S) connected to a second supply-voltage node (VSS).

4. The AFE circuit of claim 3, wherein the third bias-stage source electrode (S) is connected to the second supply-voltage node (VSS) through a second metal-oxide-semiconductor, MOS, resistor (MR2).

5. The AFE circuit of any one of claims 1 to 4, wherein the second bias-stage source electrode (S) is connected to the first supply-voltage node (VDD) through a third metal-oxide-semiconductor, MOS, resistor (MR3).

6. The AFE circuit of any one of claims 1 to 5, wherein the bias-stage circuit (220) further comprises:
a fourth bias-stage transistor (MB4) comprising a fourth bias-stage gate electrode (G), a fourth bias-stage source electrode (S) connected to a second supply-voltage node (VSS), and a fourth bias-stage drain electrode (D) connected to the fourth bias-stage gate electrode (G); and
a fifth bias-stage transistor (MB5) comprising a fifth bias-stage gate electrode (G) connected to the fourth bias-stage gate electrode (G), a fifth bias-stage source electrode (S) connected to the second supply-voltage node (VSS), and a fifth bias-stage drain electrode (D) connected to the output node (N(out)) of the AFE circuit (200).

7. The AFE circuit of claim 6, wherein the fourth bias-stage source electrode (S) is connected to the second supply-voltage node (VSS) through a fourth metal-oxide-semiconductor, MOS, resistor (MR4).

8. The AFE circuit of claim 6 or 7, wherein the bias-stage circuit (220) further comprises a sixth bias-stage transistor (MB6) comprising a sixth bias-stage gate electrode (G) connected to a third supply-voltage node (Vref), a sixth bias-stage drain electrode (D) connected to the fourth bias-stage drain electrode (D), and a sixth bias-stage source electrode (S) connected to the first supply-voltage node (VDD).

9. The AFE circuit of claim 8, wherein the sixth bias-stage source electrode (S) is connected to the first supply-voltage node (VDD) through a fifth metal-oxide-semiconductor, MOS, resistor (MR5).

10. The AFE circuit of any one of claims 6 to 9, wherein the fifth bias-stage source electrode (S) is connected to the second supply-voltage node (VSS) through a sixth metal-oxide-semiconductor, MOS, resistor (MR6).

11. The AFE circuit of any one of claims 1 to 10, wherein the first-stage circuit (210) further comprises a second first-stage transistor (MF2) comprising a second first-stage gate electrode (G) connected to the first first-stage gate electrode (G), a second first-stage source electrode (S) connected to a second supply-voltage node (VSS), and a second first-stage drain electrode (D) connected to the first first-stage drain electrode (D).

12. The AFE circuit of claim 11, wherein the second first-stage source electrode (S) is connected to the second supply-voltage node (VSS) through a first programmable capacitor (C1) and through a seventh metal-oxide-semiconductor, MOS, resistor (MR7).

13. The AFE circuit of any one of claims 1 to 12, wherein the first first-stage source electrode (S) is connected to the first supply-voltage node (VDD) through a second programmable capacitor (C2) and through an eighth metal-oxide-semiconductor, MOS, resistor (MR8).

14. The AFE circuit of any one of claims 1 to 13, wherein the input node (N(in)) of the AFE circuit (200) is configured to receive a signal from a universal chiplet interconnect express, UCle, interface.

15. A device comprising:
a first processing circuit (PU1) comprising a transmission circuit (10); and
a second processing circuit (PU2) connected to the first processing circuit (PU1) via a communication channel (CH), wherein the second processing circuit (PU2) is the AFE circuit (200) according to any one of the preceding claims.
